# EUROPÄISCHE PATENTSCHRIFT

(11) **EP 0 769 577 B1**
(45) Veröffentlichungstag und Bekanntmachung des Hinweises auf die Patenterteilung: **24.03.1999**
(21) Anmeldenummer: 96111009.5
(22) Anmeldetag: 09.07.1996
(51) Int. Cl.: C30B 15/00, C30B 15/32

(54) **Verfahren und Vorrichtung zum Ziehen von Einkristallen aus einer in einem Tiegel befindlichen Schmelze**
Process and apparatus for pulling single crystals from a melt in a crucible
Procédé et appareillage pour le tirage des monocristaux d'un bain fondu dans un creuset

(30) Priorität: 19.10.1995 DE 19538857
(43) Veröffentlichungstag der Anmeldung: 23.04.1997
(73) Patentinhaber: Balzers und Leybold Deutschland Holding AG, 63450 Hanau (DE)
(72) Erfinder: Schulmann, Winfried, 63801 Kleinostheim (DE); Thimm, Franz, 63755 Alzenau (DE); Kaiser, Helmut, Dr., 63486 Bruchköbel (DE)

(56) Entgegenhaltungen:
- EP-A- 0 460 477

## Beschreibung

Die Erfindung betrifft ein Verfahren und eine Vorrichtung zum Ziehen von Einkristallen aus einer in einem Tiegel befindlichen Schmelze unter Vakuum oder unter Schutzgas bei vermindertem Druck, wobei der Tiegel der in einer auf einem Grundgestell abgestützten Vakuumkammer auf einem Tiegeltragbolzen angeordnet und durch die Wärmestrahlung eines Heizelements erhitzbar ist und ein Ziehelement oberhalb der Schmelze vorgesehen ist, mit dem der Kristall von der Schmelzenoberfläche aus nach oben zu in eine gegenüber dem Grundgestell seitlich schwenkbare Schleusenkammer herausziehbar ist sowie mit einer Entkopplungsvorrichtung, die zwischen dem Kristall und dem Ziehelement angeordnet ist und die Trennung des Kristalls von dem Ziehelement gestattet.

Üblicherweise wird der in der Schleusenkammer am Impfling hängende Kristall von einem besonderen Handlingsystems durch die an der Schleusenkammer vorgesehene seitliche Öffnung gegriffen, dann vom Impfling abgetrennt und schließlich mit Hilfe des Handlingsystems aus der von einer Klappe verschließbaren Öffnung seitlich aus der Schleusenkammer herausgefahren.

Dies bekannte Verfahren hat eine Reihe von Nachteilen, die alle aus der besonderen Empfindlichkeit des Kristalls gegenüber Stößen und Erschütterungen resultieren. Darüber hinaus besteht die Gefahr, daß der Kristall nicht richtig vom Handlingsystem erfaßt wird, weil er in der Schleusenkammer hängend nicht frei zugänglich ist.

Es sind auch Vorrichtungen bekannt, bei denen nach dem Ziehprozeß und nach dem Belüften der Schleusenkammer diese zusammen mit der sperrigen und schweren Ziehwelle und mit dem Wellenantrieb am Gestell der Vorrichtung verschwenkt wird, so daß der Kristall auf einem unter die Schleusenkammer gefahrenen Transportwagen abgesenkt werden bzw. von diesem übernommen werden kann. Derartige Vorrichtungen haben jedoch den ganz entscheidenden Nachteil, daß bei der Größe einer Ziehvorrichtung und dem Gewicht ihrer Einzelteile die für den Ziehprozeß erforderliche Stellung der einzelnen Teile zueinander im Dauerbetrieb nicht gewährleistet werden kann, insbesondere ist es erfahrungsgemäß kaum möglich die empfindliche und hochpräzise Ziehwelle mitsamt ihrem Antrieb immer wieder winkelgenau in ihre Arbeitsposition oberhalb der Schmelze zu manövrieren.

Der vorliegenden Erfindung liegt die Aufgabe zugrunde, eine Vorrichtung des eingangs genannten Typs so auszubilden, daß der fertige Kristall sicher und stoßfrei aus der Schleusenkammer entnehmbar ist und zwar ohne daß empfindliche Teile der Vorrichtung aus ihrer Arbeitsposition entfernt werden müssen.

Gemäß der vorliegenden Erfindung wird diese Aufgabe dadurch gelöst, daß die Entkopplungsvorrichtung aus einem einen Längsschlitz aufweisenden, mit dem Ziehelement verbundenen Kuppelring, einem mit einem pilzförmigen Kopfteil versehenen mit dem Impfling verbundenen Halter und aus einem von der Deckplatte der Schleusenkammer gehaltenen Schleusenring mit auf diesem gelagerten Sperrelementen gebildet ist, wobei die Sperrelemente nach Art von Schleusentoren um horizontale Sperrelement-Kippachsen von einer horizontalen Sperrstellung in eine vertikale Öffnungsstellung und vice versa schwenkbar sind, und wobei ihre in der Sperrstellung einander zugekehrten auf der den Sperrelement-Kippachsen abgewandten Enden vorgesehenen Stirnflächen zusammen eine Öffnung bilden und, den Schaft des Impfhalters umschließend, diesen in der Ebene des Schleusenrings arretieren.

Vorzugsweise ist die seitlich verschwenkbare und in der Höhe verfahrbare Schleusenkammer fest mit dem Schleusenring verbunden, wobei die Sperrelemente eine Bewegung des Halters gegenüber dem Schleusenring aufwärts gestatten, sich gegen eine Bewegung abwärts jedoch sperren, indem sie von der auf sie einwirkenden Schwerkraft oder Federkraft unterstützt, den Durchtritt des Kopfteils des Halters verhindernd, in ihre Sperrstellung schwenken.

In einer bevorzugten Ausführungsform ist der Schleusenring mit Haltern versehen, die Photodetektoren aufweisen, die die Position des Halters zum Kuppelring ermitteln, wobei ihre Signale über einen elektrischen Schaltkreis den Hubmotor bzw. Drehmotor für das Ziehelement ansteuern und diesen in dem Augenblick ausschalten und damit das Ziehelement zum Halt bringen, in dem der Schlitz mit der von einer Tür verschließbaren Öffnung der Schleusenkammer fluchtet.

Erfindungsgemäß wird bei dem Verfahren zum Ziehen der Einkristalle nach abgeschlossenenem Ziehprozeß die von einem Schwenkarm am Obergestell gehaltene Schleusenkammer in einem ersten Verfahrensschritt angehoben, wobei der Kristall ortsfest vom Ziehelement gehalten wird und an der Schleusenkammer gehaltene Sperrelemente sich bis unter den Kristallhalter bewegen, an dem der Kristall hängt, und diesen in seiner Lage zur Schleusenkammer fixieren, und wird in einem zweiten Verfahrensschritt die Schleusenkammer zusammen mit dem Kristall um ein weiteres Maß angehoben, bis das überkragende Kopfteil des Kristallhalters von dem mit einem Schlitz versehenen kuppelring der Entkopplungsvorrichtung und damit von dem Ziehelement freikommt, wobei der Schlitz dem Durchmesser des Halsteils des Kristallhalters entspricht, und wird in einem dritten Verfahrensschritt der Kristall zusammen mit der Schleusenkammer am Schwenkarm hängend in einem horizontalen Schwenk aus dem Schlitz herausbewegt und in die Entladeposition bewegt und wird schließlich in einem vierten Verfahrensschritt der Kristall von der Hubvorrichtung oder dem Korb eines Hubwagens angehoben, wobei sich der Kristallhalter von den Sperrelementen löst und vom Kristall abgetrennt werden kann.

Die Erfindung läßt die verschiedensten Ausführungsmöglichkeiten zu; eine davon ist in den anhängenden Zeichnungen schematisch dargestellt und zwar zeigen:
- Figur 1: den Aufbau einer Vorrichtung in perspektiver Ansicht, wobei nur ihre wesentlichen Teile, und diese auch stark schematisiert, dargestellt sind,
- Figur 2: die Entkopplungsvorrichtung im Teilschnitt und in der Seitenansicht,
- Figur 3: den Kuppelring der Vorrichtung nach Figur 2 im Schnitt gemäß den Linien C - D,
- Figur 4: einen Teil der Entkopplungsvorrichtung gemäß Figur 2 in der Draufsicht, etwa gemäß den Linien A - B nach Figur 2,
- Figur 5 bis 9: verschiedene Phasen des Entkopplungsvorgangs, wobei jeweils nur Teile der Entkopplungsvorrichtung und ein Teil des Kristalls dargestellt sind und
- Figur 10: den Wagen für den Abtransport des Kristalls sowie die Teile der von der Ziehvorrichtung abgeschwenkten Schleusenkammer, in der Seitenansicht.

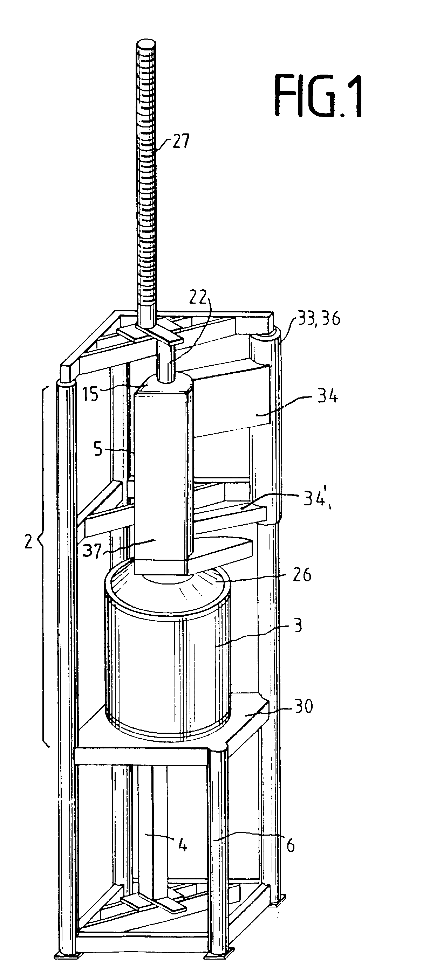

Wie Figur 1 zeigt, besteht die Ziehvorrichtung aus einem vierbeinigen Grundgestell 6 auf das ein dreibeiniges Obergestell 2 aufgesetzt ist, der auf dem Grundgestell ruhenden Vakuumkammer 3 mit dem in dieser befindlichen Tiegel und Heizung, dem von unten her in die Vakuumkammer hineinragenden Tiegeltragbolzen 4, der Schleusenkammer 5 mit Kammerdeckel 15, das von oben her in die Schleusenkammer 5 eintauchende Ziehelement 22 mit der Antriebsspindel 27 sowie den Schwenkarmen 34,34' mit Schwenklagern 33,36 für die Schleusenkammer 5.

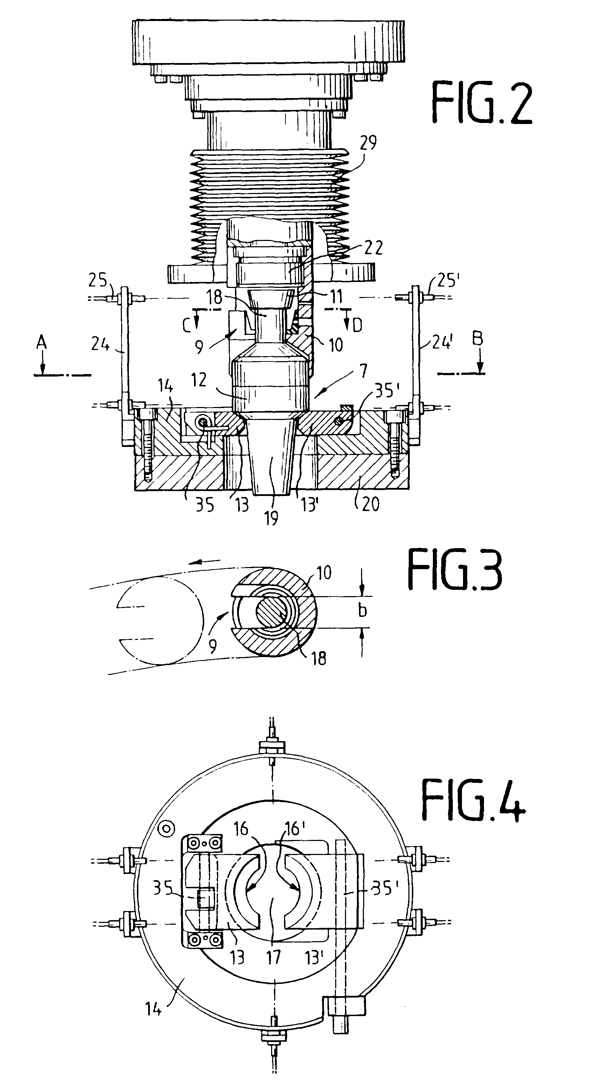

Das untere Ende des Ziehelements 22 ist (wie Figur 2 zeigt) fest mit einem Kuppelring 10 verbunden, der einen Schlitz 9 aufweist, dessen Breite b geringfügig größer bemessen ist als der Durchmesser des Halsteiles 18 des Kristallhalters 12; jedoch kleiner als der Durchmesser des pilzförmig ausgeformten Kopfteils 11.

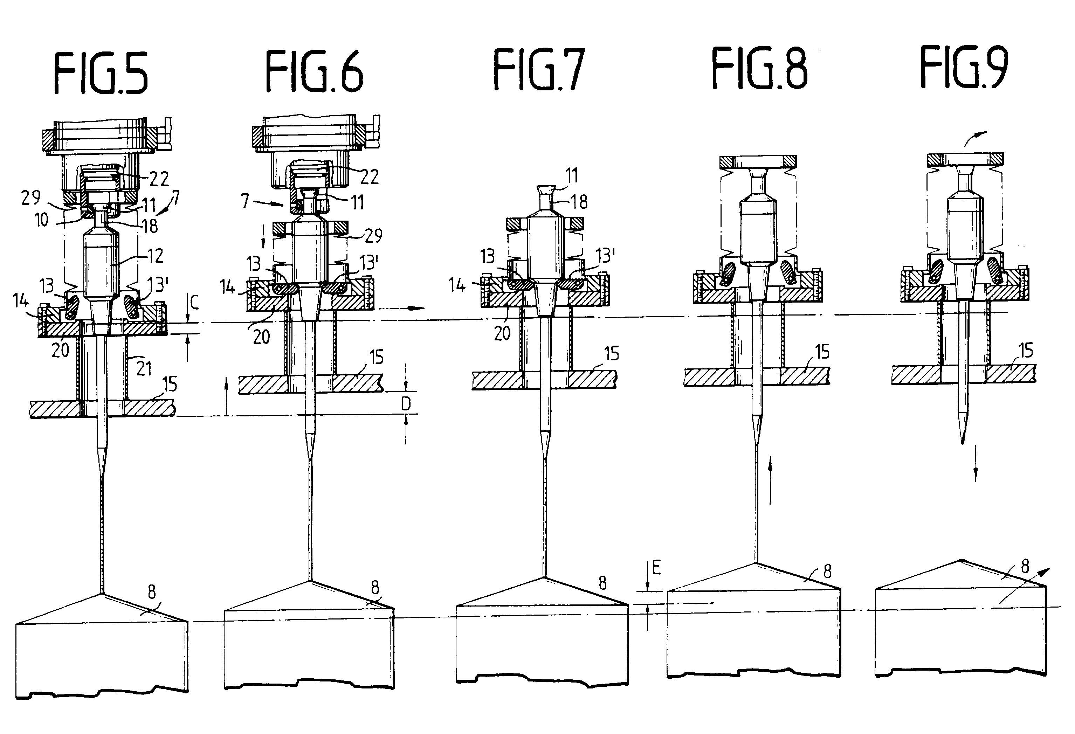

Der Kristall 8 befindet sich nach abgeschlossenem Ziehvorgang in der Schleusenkammer 5 und hängt dort am Impflingshalter 12. Nach diesem Ziehvorgang wird das Ziehelement 22 mit Drehbewegungen auf die Position gemäß Figur 5 gefahren und hält in einem bestimmten Drehwinkel an, bestimmt durch den Initiator bzw. die Photodetektoren 25, 25'. Anschließend wird die Vorrichtung bzw. die Schleusenkammer geflutet und der Balg 29 von der Schleusenkammer 5 mittels Pneumatikzylinder abgehoben. Über Federkraft und Eigengewicht schwenken nun die beiden Sperrelemente 13, 13' in Pfeilrichtung in die horizontale Lage (Sperrstellung) wie dies Figur 6 zeigt.

Durch Anheben der Schleusenkammer 5 bzw. des oberen Deckels 15 setzt sich der Impflingshalter 12 mit angehängtem Kristall 8 auf den Sperrelementen 13, 13' ab. Durch kontinuierlichen weiteren Schleusenhub auf das Maß D löst sich der Impflingshalter von dem Ziehelement 22, wobei das pilzförmige Kopfteil 11 (Figur 2 bzw. 6) vom Kuppelring 10 abhebt bzw. freikommt.

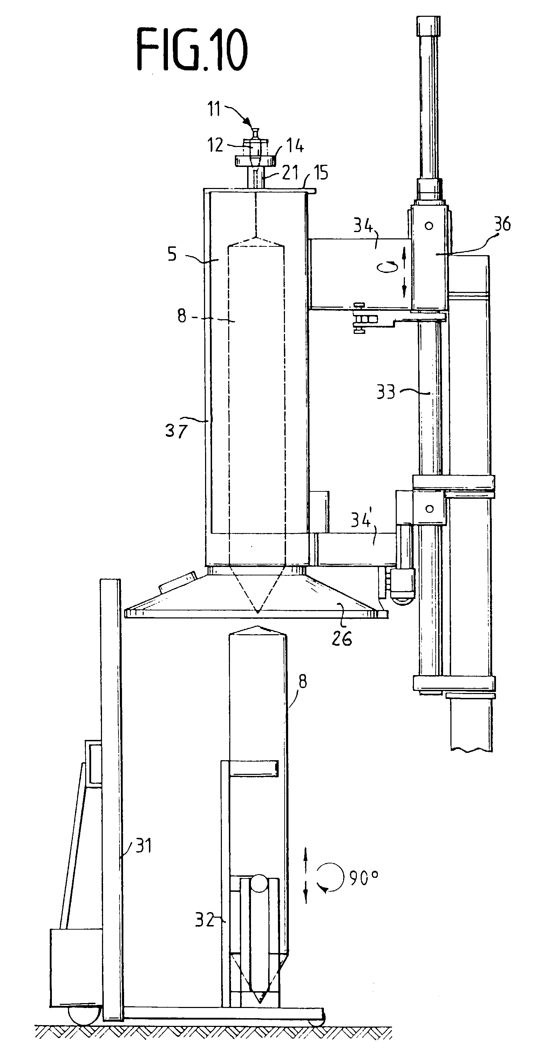

Danach wird die mit der Schleusenkammertür 37 verschließbare Schleusenkammer 5 mit Kristall 8 und dem Impflingshalter 12 um einen Winkel von ca. 90° hydraulisch oder elektrisch um die Welle 33 am Schwenkarm 34, 34' hängend geschwenkt und zwar bis in die in Figur 10 bzw. Figur 7 dargestellte Position. Bei dieser Schwenkbewegug um die Welle 33 bewegt sich das Halsteil 18 aus dem Längsschlitz 9, dessen Breite b geringfügig größer bemessen ist als der Durchmesser des Halsteils 18, jedoch kleiner bemessen ist als der Durchmesser des pilzförmigen Kopfteils 11.

Um genügend Freiraum zwischen Kristall 8 und Operator-Flur 30 zu bekommen, wird die komplette Schleusenkammer 5 nochmals um ca. 30 mm angehoben wie dies Figur 8 zeigt.

Anschließend wird ein fahrbarer Hubwagen 31 unter die Schleusenkammer 5 gefahren und ein Korb 32 nach oben gefahren, bis der Kristall 8 aufsitzt bzw. die Schleusenkammer gegenüber dem Kristall um ca. 300 mm abgesenkt ist (Maß E). Danach wird die Schleusenkammer 5 geöffnet und der Impfling abgeschnitten.

Der Hubwagen 31 wird mit dem Kristall 8 abgesenkt und weggefahren.

Nach dem Anheben und Schließen der Schleusenkammer 5 wird diese wieder zurückgeschwenkt und nach dem umgekehrten restlichen Spielablauf ist die Vorrichtung wieder startbereit.

Bei sehr langen Kristallen 8 wird an der Hubhydraulik ein Rastbolzen positioniert und damit wird der Ziehkessel bzw. die Vakuumkammer 3 mit der Schleusenkammer 5 fest verbunden. Beim Anheben und Schwenken der Schleusenkammer 5 folgt der Ziehkessel 3 immer mit.

Dieser Vorgang ist für die Reinigung des Ziehkessels 3 erforderlich. Hier wird der Ziehkessel 3 nach dem Schwenken auf einen Nocken abgesetzt, die Schleusenkammer angehoben und wieder eingeschwenkt. Danach kann der Ziehkessel geschwenkt und gereinigt werden.

Das Zusammensetzen der Vorrichtung erfolgt in umgekehrter Reihenfolge.

Zu bemerken ist, daß eine Kristallentnahme auch im zusammengefahrenen Zustand der Vorrichtung durch die geöffnete Tür 37 immer möglich ist.

### Bezugszeichenliste

- 2: Obergestell
- 3: Vakuumkammer
- 4: Tiegeltragbolzen
- 5: Ziehkammer, Schleusenkammer
- 6: Grundgestell
- 7: Entkopplungsvorrichtung
- 8: Kristall
- 9: Längsschlitz
- 10: geschlitzter Ring, Kuppelring
- 11: pilzförmiges Kopfteil
- 12: Halter, Kristallhalter
- 13, 13': Sperrelement
- 14: Schleusenring
- 15: Kammerdeckel
- 16, 16': Stirnflächen
- 17: Öffnung
- 18: Halsteil
- 19: Schaft
- 20: Flansch
- 21: Stützrohr
- 22: Ziehelement
- 23: Faltenbalg
- 24, 24': Halter
- 25, 25': Photodetektor
- 26: Vakuumkammerdeckel
- 27: Antriebsspindel
- 29: Balg
- 30: Operator-Flur
- 31: Hubwagen
- 32: Korb
- 33: Welle
- 34: Schleusenkammerhalter
- 35, 35': Sperrelement-Kippachse
- 36: Schwenklager
- 37: Schleusenkammertür

## Patentansprüche

1. Vorrichtung zum Ziehen von Einkristallen aus einer in einem Tiegel befindlichen Schmelze unter Vakuum oder unter Schutzgas bei vermindertem Druck, wobei der Tiegel in einer auf einem Grundgestell (6) abgestützten Vakuumkammer (3) auf einem Tiegeltragbolzen (4) angeordnet und durch die Wärmestrahlung eines Heizelements erhitzbar ist und wobei ein Ziehelement (22) oberhalb der Schmelze vorgesehen ist, mit dem der Kristall (8) von der Schmelzenoberfläche aus nach oben zu in eine gegenüber dem Grundgestell (6) seitlich schwenkbare Schleusenkammer (5) herausziehbar ist sowie mit einer Entkopplungsvorrichtung (7) , die zwischen dem Kristall (8) und dem Ziehelement vorgesehen ist und die Trennung des Kristalls (8) von dem Ziehelement (22) gestattet, **dadurch gekennzeichnet,** das die Entkopplungsvorrichtung (7) aus einem einen Längsschlitz (9) aufweisenden, mit dem Ziehelement (22) verbundenen Kuppelring (10), einem mit einem pilzförmigen Kopfteil (11) versehenen mit dem Impfling verbundenen Halter (12) und aus einem von der Deckplatte (15) der Schleusenkammer (5) gehaltenen Schleusenring (14) mit auf diesem gelagerten Sperrelementen (13, 13') gebildet ist, wobei die Sperrelemente (13, 13') nach Art von Schleusentoren um horizontale Sperrelement-Kippachsen (35, 35') von einer horizontalen Sperrstellung in eine vertikale Öffnungsstellung und vice versa schwenkbar sind, und wobei ihre in der Sperrstellung einander zugekehrten auf der den Sperrelement-Kippachsen (35, 35') abgewandten Enden vorgesehenen Stirnflächen (16, 16') zusammen eine Öffnung (17) bilden und, den Schaft (19) des Impfhalters (12) umschließend, diesen in der Ebene des Schleusenrings (14) arretieren.

2. Vorrichtung nach Anspruch 1, **dadurch gekennzeichnet,** daß die seitlich verschwenkbare und in der Höhe verfahrbare Schleusenkammer (5) fest mit dem Schleusenring (14) verbunden ist und die Sperrelemente (13, 13') eine Bewegung des Halters (12) gegenüber dem Schleusenring (14) aufwärts gestatten, sich gegen eine Bewegung abwärts jedoch sperren, indem sie von der auf sie einwirkenden Schwerkraft oder Federkraft unterstützt, den Durchtritt des Kopfteils (11) des Halters (12) verhindernd, in ihre Sperrstellung schwenken.

3. Vorrichtung nach Anspruch 1, **dadurch gekennzeichnet,** daß der Schleusenring (14) mit Haltern (24, 24') versehen ist die Photodetektoren (25, 25') aufweisen, die die Position des Halters (12) zum Kuppelring (10) ermitteln, wobei ihre Signale über einen elektrischen Schaltkreis den Hubmotor bzw. Drehmotor für das Ziehelement (22) ansteuern und diesen in dem Augenblick ausschalten und damit das Ziehelement zum Halt bringen, in dem der Schlitz (9) mit der von einer Tür (37) verschließbaren Öffnung der Schleusenkammer (5) fluchtet.

4. Verfahren zum Ziehen von Einkristallen aus einer in einem Tiegel befindlichen Schmelze unter Vakuum oder unter Schutzgas bei vermindertem Druck, wobei der Tiegel in einer auf einem Grundgestell (6) gelagerten Vakuumkammer (3) angeordnet ist und wobei ein auf einem vom Grundgestell (6) gehaltenen Obergestell (2) abgestütztes Ziehelement (22) oberhalb der Schmelze vorgesehen ist, mit dem der Kristall (8) von der Schmelzenoberfläche aus nach oben zu in eine gegenüber dem Grundgestell (6) seitlich schwenkbare Schleusenkammer (5) herausziehbar ist sowie mit einer Entkopplungsvorrichtung (7), die zwischen dem Kristall (8) und dem Ziehelement vorgesehen ist und die Trennung des Kristalls (8) von dem Ziehelement (22) gestattet, **dadurch gekennzeichnet,** das nach abgeschlossenem Ziehprozeß die von einem Schwenkarm (34, 34') am Obergestell (2) gehaltene Schleusenkammer (5) in einem ersten Schritt angehoben wird, wobei der Kristall (8) ortsfest vom Ziehelement (22) gehalten wird und an der Schleusenkammer (5) gehaltene Sperrelemente (13, 13') sich bis unter den Kristallhalter (12) bewegen, an dem der Kristall (8) hängt, und diesen in seiner Lage zur Schleusenkammer (5) fixieren und in einem zweiten Schritt die Schleusenkammer (5) zusammen mit dem Kristall (8) um ein weiteres Maß angehoben wird, bis das überkragende Kopfteil (11) des Kristallhalters (12) von dem mit einem Schlitz (9) versehenen Kuppelring (10) der Entkopplungsvorrichtung (7) und damit von dem Ziehelement (22) freikommt, wobei der Schlitz dem Durchmesser des Halsteils (18) des Kristallhalters (12) entspricht, und in einem dritten Schritt der Kristall (8) zusammen mit der Schleusenkammer (5) am Schwenkarm (34,34') hängend in einem horizontalen Schwenk aus dem Schlitz (9) herausbewegt und in die Entladeposition bewegt wird und in einem vierten Schritt der Kristall (8) von der Hubvorrichtung oder dem Korb eines Hubwagens (31) angehoben wird, wobei sich der Kristallhalter (12) von den Sperrelementen löst und vom Kristall (8) abgetrennt werden kann.

## Claims

1. A device for drawing mono-crystals from a melt located in a crucible under vacuum or under protective gas at reduced pressure, wherein the crucible is arranged on a crucible bearing bolt (4) in a vacuum chamber (3) supported on a base frame (6) and may be heated by the heat radiated by a heating element and wherein a drawing member (22) is provided above the melt, with which the crystal (8) may be drawn upwards out of the melt surface into a lock chamber (5) swivellable laterally with respect to the base frame (6), an uncoupling device (7) also being provided, which is arranged between the crystal (8) and the drawing member and permits separation of the crystal (8) from the drawing member (22), **characterised in that** the uncoupling device (7) comprises a coupling ring (10) comprising a longitudinal slot (9) and connected with the drawing member (22), a holder (12) provided with a mushroom-shaped head part (11) and connected with the seed and a lock ring (14) supported by the cover plate (15) of the lock chamber (5) and having retaining elements (13, 13') mounted thereon, wherein the retaining elements (13, 13') may be swivelled in the manner of lock gates about horizontal retaining element tilting axes (35, 35') from a horizontal retaining position into a vertical open position and vice versa, and wherein their end faces (16, 16'), provided at the ends remote from the retaining element tilting axes (35, 35') and facing each other in the retaining position together form an opening (17) and, by enclosing the shank (19) of the seed holder (12), arrest the latter in the plane of the lock ring (14).

2. A device according to claim 1, **characterised in that** the laterally swivellable, vertically displaceable lock chamber (5) is preferably connected firmly with the lock ring (14) and the retaining elements (13, 13') permit movement of the holder (12) upwards with respect to the lock ring (14) but block any movement downwards by swivelling, with the assistance of the gravity or spring force acting thereon, into their retaining position which prevents passage of the head part (11) of the holder (12).

3. A device according to claim 1, **characterised in that** the lock ring (14) is provided with holders (24, 24') which comprise photodetectors (25, 25') which detect the position of the holder (12) with respect to the coupling ring (10), wherein the signals thereof actuate the lifting motor or turning motor for the drawing member (22) via an electric circuit, switching said motor off and thus bringing the drawing member to a halt at the point when the slot (9) is aligned with the opening, closable by a door (37), of the lock chamber (5).

4. A method of drawing mono-crystals from a melt located in a crucible under vacuum or under protective gas at reduced pressure, wherein the crucible is arranged in a vacuum chamber (3) mounted on a base frame (6) and wherein a drawing member (22) is provided above the melt on an upper frame (2) supported by the base frame (6), with which drawing member (22) the crystal (8) may be drawn upwards out of the melt surface into a lock chamber (5) swivellable laterally with respect to the base frame (6), an uncoupling device (7) also being provided, which is arranged between the crystal (8) and the drawing member and permits separation of the crystal (8) from the drawing member (22),
**characterised in that,** when the drawing process is complete, the lock chamber (5), held on the upper frame (2) by a swivel arm (34, 34'), is raised in a first step, wherein the crystal (8) is held stationarily by the drawing member (22) and retaining elements (13, 13') supported on the lock chamber (5) move to below the crystal holder (12) on which the crystal (8) is suspended and fix said holder (12) in its position in relation to the lock chamber (5), and in a second step the lock chamber (5) is raised together with the crystal (8) by a further amount until the projecting head part (11) of the crystal holder (12) is released by the coupling ring (10), provided with a slot (9), of the uncoupling device (7) and thus by the drawing member (22), wherein the slot corresponds to the diameter of the neck part (18) of the crystal holder (12), and in a third step the crystal (8) is moved, together with the lock chamber (5) suspended on the swivel arm (34, 34'), in a horizontal swivelling movement out of the slot (9) and into the discharge position and in a fourth step the crystal (8) is raised by the lifting device or the basket of a lift truck (31), wherein the crystal holder (12) is released by the retaining elements and may be separated from the crystal (8).

## Revendications

1. Appareillage pour le tirage de monocristaux à partir d'un bain de fusion se trouvant dans un creuset, sous vide ou sous gaz de protection sous pression réduite, dans lequel le creuset est disposé sur une colonne porte-creuset (4) dans une chambre sous vide (3) posée sur un châssis de base (6) et peut être chauffé par le rayonnement thermique d'un élément de chauffage et dans lequel est prévu au-dessus du bain de fusion un élément de tirage (22) au moyen duquel le cristal (8) peut être tiré hors de la surface du bain de fusion, vers le haut, dans un sas d'écluse pouvant pivoter latéralement par rapport au châssis de base (6), et comportant aussi un dispositif de découplage (7) qui est prévu entre le cristal (8) et l'élément de tirage et autorise la séparation du cristal (8) d'avec l'élément de tirage (22), caractérisé par le fait que le dispositif de découplage (7) est formé d'un anneau de couplage présentant une fente longitudinale (9) et lié à l'élément de tirage (22), d'un support présentant une partie de tête en forme de champignon (11) et lié au germe cristallin et d'un anneau de sas (14) tenu par la plaque de couverture (15) du sas (5), les éléments de verrouillage (13, 13') pouvant, à la façon de portes de sas d'écluse, pivoter autour d'axes de pivotement horizontaux d'éléments de verrouillage (35, 35') pour passer d'une position horizontale de verrouillage à une position verticale d'ouverture et vice versa, et leurs surfaces frontales (16, 16') tournées l'une vers l'autre en position de verrouillage et prévues sur les extrémités opposées aux axes de pivotement de l'élément de verrouillage (35, 35') formant ensemble une ouverture (17) et, enserrant le fût (19) du support (12) du germe cristallin, verrouillent celui-ci dans le plan de l'anneau de sas (14).

2. Appareillage selon la revendication 1, caractérisé par le fait que le sas d'écluse (5), qui peut pivoter latéralement et se déplacer en hauteur, est solidairement relié à l'anneau de sas (14) et que les éléments de verrouillage (13, 13') autorisent un mouvement du support (12) vers le haut, vis à vis de l'anneau de sas (14), mais s'opposent à un mouvement vers le bas en ce sens que, aidés par la pesanteur qui agit sur eux ou la force d'un ressort, ils pivotent dans leur position de verrouillage, interdisant le passage de la partie de tête (11) du support (12).

3. Appareillage selon la revendication 1, caractérisé par le fait que l'anneau de sas (14) est muni de supports (24, 24') qui présentent des photodétecteurs (25, 25') qui déterminent la position du support (12) par rapport à l'anneau de couplage (10), leurs signaux commandant, par l'intermédiaire d'un circuit électrique, le moteur de levée ou le moteur de rotation pour l'élément de tirage (22) et mettant hors circuit ce moteur et faisant donc arrêter l'élément de tirage à l'instant où la fente (9) est alignée avec l'ouverture du sas (5) que peut obturer une porte (37).

4. Procédé pour le tirage de monocristaux à partir d'un bain de fusion se trouvant dans un creuset, sous vide ou sous gaz de protection sous pression réduite, dans lequel le creuset est disposé dans une chambre sous vide (3) posée sur un châssis de base (6) et dans lequel est prévu, au-dessus du bain de fusion, un élément de tirage (22) qui est posé sur un châssis supérieur (2) maintenu par le châssis de base (6), au moyen duquel le cristal (8) peut être tiré hors de la surface du bain de fusion, vers le haut, dans un sas d'écluse pouvant pivoter latéralement par rapport au châssis de base (6), et comportant aussi un dispositif de découplage (7) qui est prévu entre le cristal (8) et l'élément de tirage et autorise la séparation du cristal (8) d'avec l'élément de tirage (22), caractérisé par le fait qu'après achèvement du processus de tirage, le sas (5), maintenu par un bras pivotant (34, 34') sur le châssis supérieur (2), est, dans un premier pas, soulevé, le cristal (8) étant maintenu fixe par l'élément de tirage (22) et que des éléments de verrouillage (13, 13'), maintenus sur le sas (5), se meuvent jusqu'en dessous du support du cristal (12) auquel le cristal (8) est suspendu et fixent celui-ci dans sa position par rapport au sas (5), et que dans un second pas, le sas (5) est soulevé, avec le cristal (8), sur une autre distance, jusqu'à ce que la partie de tête (11), surplombante, du support du cristal (12), soit libérée d'avec l'anneau de couplage (10), muni d'une fente (9), du dispositif de découplage (7) et donc de l'élément de tirage (22), la fente correspondant au diamètre de la partie formant col (18) du support du cristal (12) et que, dans un troisième pas, le cristal (8), en même temps que le sas (5) suspendu au bras pivotant (34, 34'), sort de la fente (9) dans un pivotement horizontal et vient dans la position de déchargement et que, dans un quatrième pas, le cristal (8) est soulevé par le dispositif de levage ou par le panier d'un chariot élévateur (31), le support du cristal (12) pouvant se déverrouiller d'avec les éléments de verrouillage et se séparer du cristal (8).
